# EUROPEAN PATENT APPLICATION

(11) **EP 1 684 298 A2**
(43) Date of publication of application: **26.07.2006**
(21) Application number: 06250255.4
(22) Date of filing: 18.01.2006
(51) Int. Cl.: G11B 33/08, G11B 31/00

(54) **Electronic equipment comprising shock sensitive memory device**

(30) Priority: 24.01.2005 JP 2005015969
(71) Applicant: NIKON CORPORATION, Tokyo 100-8331 (JP)
(72) Inventor: Omi, Junichi c/o Nikon Corporation, Tokyo, 100-8331 (JP)
(74) Representative: Whitlock, Holly Elizabeth Ann

(57) **Abstract**

An object is to provide an electronic equipment satisfying both compactness and resistance to a shock and a shake in spite of being equipped with a memory device such as an HDD or the like vulnerable to a shock. The electronic equipment (100) includes a memory device (13) that stores data and is vulnerable to a shock, and a circuit board (1) that has a control circuit for controlling the electronic equipment (100) and an opening portion (9). The memory device (13) is held at the opening portion (9) through a holding member (11), which is made of an impact absorbing material.

## Description

The disclosure of the following priority application is herein incorporated by reference:
Japanese Patent Application No. 2005-015969 filed on January 24, 2005.

### BACKGROUND OF THE INVENTION

### Field of the Invention

The present invention relates to a compact electronic equipment such as a digital camera, a digital audio equipment, or the like equipped with a mass storage vulnerable to a shock.

### Related Background Art

Recently, a compact electronic equipment such as a digital camera, a digital audio equipment, or the like equipped with a high-capacity hard disk drive (hereinafter called an "HDD") as a mass storage has been put on the market. Since a high-capacity hard disk drive is vulnerable to a shock and a shake, upon being installed in an electronic equipment the HDD is protected from a shock and a shake by packing it up with a shock absorber or a vibration absorber (for example, see Japanese Patent Application Laid-Open No. 2003-242764).

Nowadays, a digital camera or a portable audio equipment equipped with an HDD is being expected to become further compact. However, in the embodiment of Japanese Patent Application Laid-Open No. 2003-242764, an HDD packed with a shock absorber or a vibration absorber is disposed in the vicinity of a circuit board including a controller circuit of an electronic equipment through an insulator, so that it causes a problem that the dimension of the electronic equipment becomes thick.

### SUMMARY OF THE INVENTION

The present invention is made in view of the aforementioned problems and has an object to provide an electronic equipment satisfying both compactness and resistance to a shock and a shake in spite of being equipped with a memory device such as an HDD vulnerable to a shock.

According to one aspect of the present invention, there is provided an electronic equipment including a memory device that stores data thereon, a circuit board that has an opening portion and a control circuit for controlling the electronic equipment, and a holding member that holds the memory device at the opening portion.

In the aspect of the present invention, it is characterized in that the memory device is vulnerable to a shock.

In the aspect of the present invention, it is preferable that the opening portion is formed by cutting out at least one side of the circuit board.

In the aspect of the present invention, it is preferable that at least one side of the holding member makes contact with a casing.

In the aspect of the present invention, it is preferable that the electronic equipment further comprises a flexible printed circuit board that electrically connects the memory device to the circuit board.

In the aspect of the present invention, it is preferable that the holding member is made of an impact-absorbing material.

Other features and advantages according to the invention will be readily understood from the detailed description of the preferred embodiment in conjunction with the accompanying drawings.

### BRIEF DESCRIPTION OF THE DRAWINGS

Fig. 1 is a cross sectional view of an electronic equipment according to a first embodiment of the present invention sectioned along an A-A line in Fig. 2.
Fig. 2 is a cross sectional view of the electronic equipment sectioned along a B-B line in Fig. 1.
Fig. 3 is a cross sectional view of the electronic equipment sectioned along a C-C line in Fig. 1.
Fig. 4 is a cross sectional view of an electronic equipment according to a variation of the present invention sectioned along an A-A line in Fig. 5.
Fig. 5 is a cross sectional view of the electronic equipment sectioned along a B-B line in Fig. 4.
Fig. 6 is a cross sectional view of the electronic equipment sectioned along a C-C line in Fig. 4.

### DESCRIPTION OF THE MOST PREFERRED EMBODIMENTS

Embodiments according to the present invention is explained below with reference to accompanying drawings.

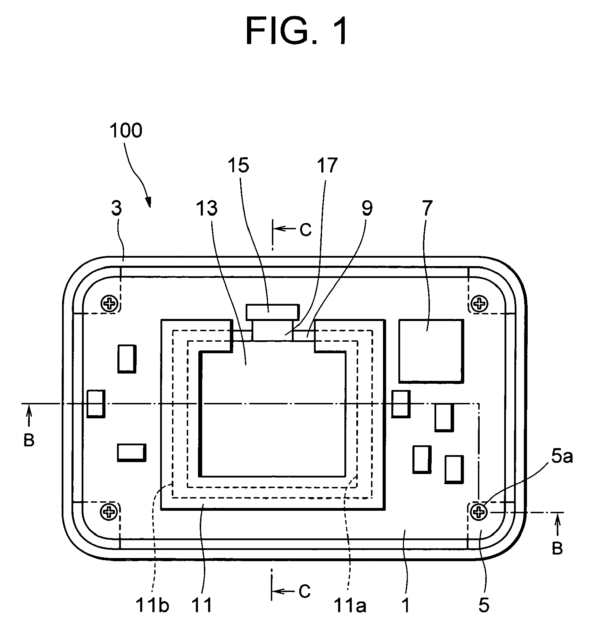

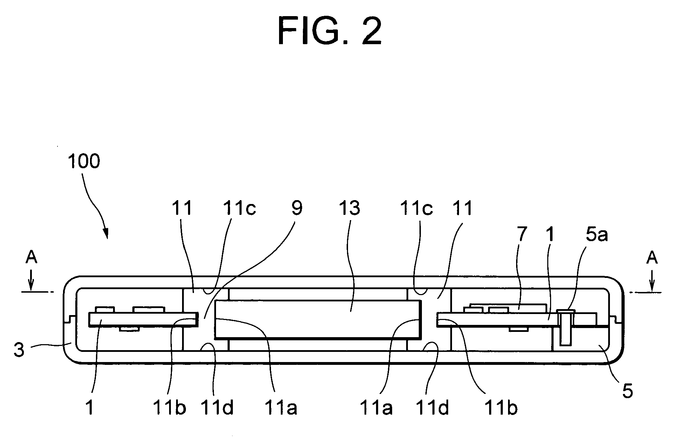

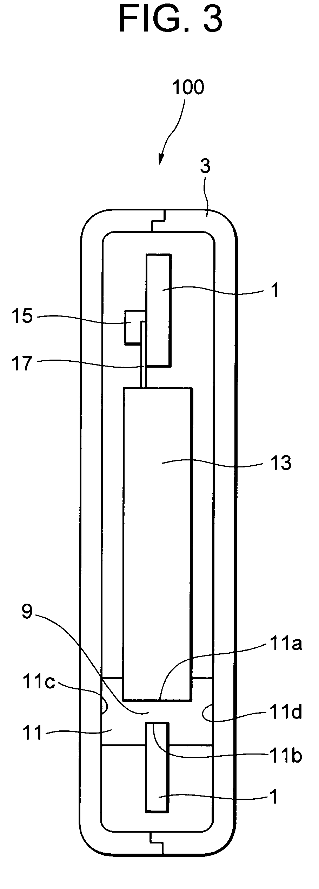

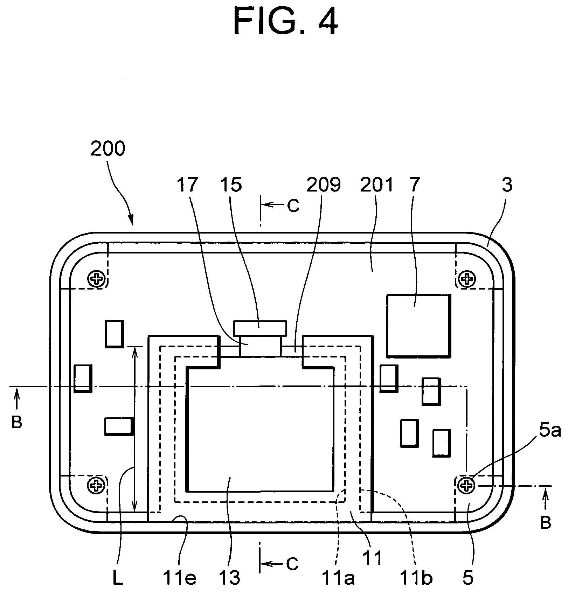

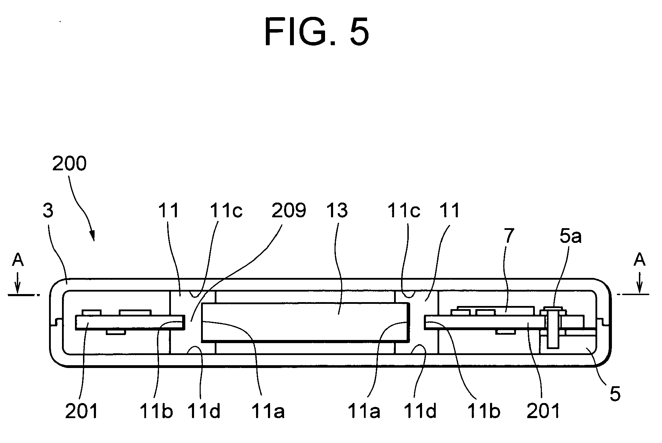

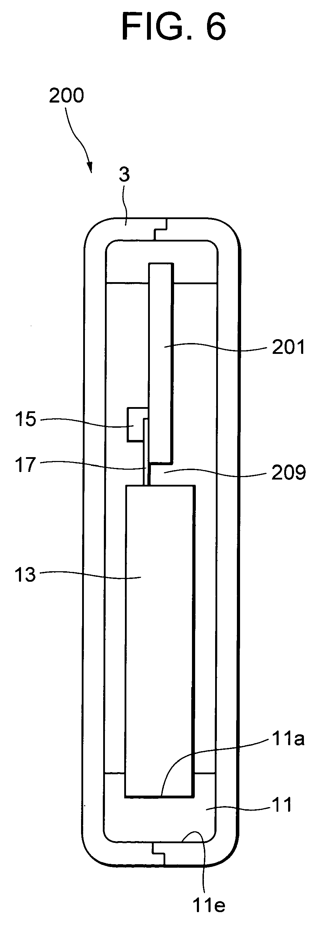

Fig. 1 is a cross sectional view of an electronic equipment according to a first embodiment of the present invention sectioned along an A-A line in Fig. 2. Fig. 2 is a cross sectional view of the electronic equipment sectioned along a B-B line in Fig. 1. Fig. 3 is a cross sectional view of the electronic equipment sectioned along a C-C line in Fig. 1. Fig. 4 is a cross sectional view of an electronic equipment according to a variation of the present invention sectioned along an A-A line in Fig. 5. Fig. 5 is a cross sectional view of the electronic equipment sectioned along a B-B line in Fig. 4. Fig. 6 is a cross sectional view of the electronic equipment sectioned along a C-C line in Fig. 4.

### <FIRST EMBODIMENT>

In Figs. 1 to 3, reference number 1 denotes a circuit board that is fixed to a casing 3, with being separated from inner walls thereof, through holder portions 5 disposed at four corners of the casing 3 of an electronic equipment 100. In order to fix the circuit board 1 to the holder portions 5, a fixing means such as a screw 5a or the like is used. The fixing means is not limited to the screw 5a and a clip or the like may be used. Each of electronic parts 7 for controlling the electronic equipment 100 is mounted and wired on the circuit board 1. An opening portion 9 having a square shape is provided at the center of the circuit board 1 and a hard disk drive 13 (hereinafter abbreviated as an "HDD") is held in the space of the casing 3 through a holding member 11.

The holding member 11 is formed approximately into a loop having a square shape with a cutout area where a flexible printed circuit board 17 (hereinafter abbreviated as an "FPC") for electrically connecting a connector 15 on the circuit board 1 to the HDD 13 is disposed. Since the FPC 17 connects the HDD 13 to the connector 15 with an allowance so that the FPC 17 may be deformed, even if the HDD 13 is displaced due to a shock or a shake, the electrical connection between the HDD 13 and the connector 15 can be secured.

As shown in Fig. 2, the cross sectional shape of the holding member 11 along the B-B line is a rectangle. In an inner circumference of the holding member 11, there is formed a groove 11a almost all the way around for holding the HDD 13 by fitting therein. In the groove 11a, the HDD 13 is fitted almost all the way around to be held on the outer circumference thereof by the holding member 11. In an outer circumference of the holding member 11, there is formed a groove 11b almost all the way around in which edges of the opening portion 9 of the circuit board 1 are fitted to hold the holding member 11. Accordingly, it becomes possible to hold the HDD 13 at the opening portion 9 of the circuit board 1 through the holding member 11 without touching inner wall of the casing 3.

Incidentally, in Figs. 2 and 3, the HDD 13 may be held such that both of the upper surface 11c (upper side in Fig. 2) and the lower surface 11d (lower side in Fig. 2) of the holding member 11 are separated from the inner wall of the casing 3 or such that at least one surface of the upper surface 11c and the lower surface 11d of the holding member 11 makes contact with the inner wall of the casing 3. In this manner, the electronic equipment equipped with a memory device which is vulnerable to a shock and a shake is constructed.

In the first embodiment of the present invention, the holding member 11 is made of an elastic body (a gel-type material such as rubber, urethane resin, silicone resin, or the like) to absorb a shock and a shake from outside of the casing 3 in order to protect the HDD 13 from a malfunction or a breakdown. Moreover, since the HDD 13 is held at the opening portion 9 of the circuit board 1 through the holding member 11, the whole thickness of the electronic equipment 100 including the circuit board 1 and the HDD 13 can be thinner than that of a conventional construction that the circuit board 1 is disposed in the vicinity of one side of the HDD 13.

### <VARIATION>

Then, a variation of the present invention is explained with reference to Figs. 4 through 6.

The variation is different from the first embodiment in that the opening portion is formed by cutting out at least one side of the circuit board, so that it is explained with attaching the same reference numbers to the similar constructions to the first embodiment.

In Figs. 4 to 6, reference number 201 denotes a circuit board that is fixed to a casing 3, with being separated from inner walls thereof, through holder portions 5 disposed at four corners of the casing 3 of an electronic equipment 200. In order to fix the circuit board 201 to the holder portions 5, a fixing means such as a screw 5a or the like is used. The fixing means is not limited to the screw 5a and a clip or the like may be used. Each of electronic parts 7 for controlling the electronic equipment 200 is mounted and wired on the circuit board 201. An opening portion 209 having a square shape is provided at the lower side portion (lower side in Fig. 4) of the circuit board 201 and a hard disk drive 13 (hereinafter abbreviated as an "HDD") is held in the space of the casing 3 through a holding member 11.

The holding member 11 is formed approximately into a loop having a square shape with a cutout area where a flexible printed circuit board 17 (hereinafter abbreviated as an "FPC") for electrically connecting a connector 15 on the circuit board 201 to the HDD 13 is disposed. Since the FPC 17 connects the HDD 13 to the connector 15 with an allowance so that the FPC 17 may be deformed, even if the HDD 13 is displaced due to a shock or a shake, the electrical connection between the HDD 13 and the connector 15 can be secured.

As shown in Fig. 5, the cross sectional shape of the holding member 11 along the B-B line is substantially rectangular. In an inner circumference of the holding member 11, there is formed a groove 11a almost all the way around for holding the HDD 13 by fitting therein. In the groove 11a, the HDD 13 is fitted almost all the way around to be held on the outer circumference by the holding member 11. In an outer circumference of the holding member 11, there is formed a groove 11b in which edges of the opening portion 209 of the circuit board 201 are fitted to hold the holding member 11 on three sides except one side 11e where the holing member 11 makes contact with the inner wall of the casing 3. Moreover, the side wall portion 11e of the outer circumference of the holding member 11 makes contact with the inner wall of the casing 3. Accordingly, it becomes possible to hold the HDD 13 at the opening portion 209 of the circuit board 201 by means of the holding member 11 and by making the side wall portion 11e of the outer circumference of the holding member 11 contact with the inner wall of the casing 3. In this manner, the electronic equipment equipped with a memory device which is vulnerable to a shock and a shake is constructed. Incidentally, the opening portion 209 formed on the circuit board 201 may be formed on any other side of the circuit board 201. In addition, the cutout length L (see Fig. 4) may be suitably changed in accordance with the corresponding side length of the HDD 13.

Incidentally, in Figs. 5 and 6, similar to the first embodiment, the HDD 13 may be held such that both of the upper surface 11c (upper side in Fig. 5) and the lower surface 11d (lower side in Fig. 5) of the holding member 11 are separated from the inner wall of the casing 3 or such that at least one surface of the upper surface 11c and the lower surface 11d of the holding member 11 makes contact with the inner wall of the casing 3.

In the variation of the present invention, the holding member 11 is made of an elastic body (a gel-type material such as rubber, urethane resin, silicone resin, or the like) to absorb a shock and a shake from outside of the casing 3 in order to protect the HDD 13 from a malfunction or a breakdown. Moreover, since the HDD 13 is held at the opening portion 209 of the circuit board 201 through the holding member 11, the whole thickness of the electronic equipment 200 including the circuit board 201 and the HDD 13 can be thinner than that of a conventional construction that the circuit board 201 is disposed in the vicinity of one side of the HDD 13.

In the first embodiment and the variation of the present invention, although the explanation is made in a case that the memory device to be protected is an HDD 13, it is not limited to the HDD 13. The present invention can be applied to hold a memory device vulnerable to a shock and a shake, such as an optical disk drive, and the like.

An electronic equipment equipped with the memory device according to the first embodiment or the variation of the present invention makes it possible to construct a portion or the whole of an equipment such as a digital camera, a digital video camera, a portable digital audio equipment, a portable MP3 equipment, a PDA equipment, a portable measuring instrument, and the like.

Additional advantages and modifications will readily occur to those skilled in the art. Therefore, the invention in its broader aspects is not limited to the specific details, and representative devices shown and described herein. Accordingly, various modifications may be made without departing from the spirit or scope of the general inventive concept as defined by the appended claims and their equivalents.

## Claims

1. An electronic equipment comprising:
a memory device that stores data thereon;
a circuit board that has an opening portion and a control circuit for controlling the electronic equipment; and
a holding member that holds the memory device at the opening portion.

2. The electronic equipment according to claim 1, wherein the memory device is vulnerable to a shock.

3. The electronic equipment according to claim 2, wherein the opening portion is formed by cutting out at least one side of the circuit board.

4. The electronic equipment according to claim 2, wherein at least one side of the holding member makes contact with a casing.

5. The electronic equipment according to claim 2, further comprising a flexible printed circuit board that electrically connects the memory device to the circuit board.

6. The electronic equipment according to claim 2, wherein the holding member is made of an impact-absorbing material.

7. The electronic equipment according to claim 3, wherein at least one side of the holding member makes contact with the casing.

8. The electronic equipment according to claim 3, wherein the holding member is made of an impact-absorbing material.

9. The electronic equipment according to claim 7, wherein the holding member is made of an impact-absorbing material.

10. The electronic equipment according to claim 4, wherein the holding member is made of an impact-absorbing material.

11. The electronic equipment according to claim 4, further comprising a flexible printed circuit board that electrically connects the memory device to the circuit board.

12. The electronic equipment according to claim 10, further comprising a flexible printed circuit board that electrically connects the memory device to the circuit board.
